Europäisches Patentamt

European Patent Office

Office européen des brevets

(11) Veröffentlichungsnummer: **0 337 342**
**A1**

## (12) EUROPÄISCHE PATENTANMELDUNG

(21) Anmeldenummer: 89106277.0

(22) Anmeldetag: 10.04.89

(51) Int. Cl.⁴: **C25F 5/00** , **H01L 21/312**

(30) Priorität: 13.04.88 DE 3812315

(43) Veröffentlichungstag der Anmeldung:
18.10.89 Patentblatt 89/42

(84) Benannte Vertragsstaaten:
AT BE CH DE FR GB IT LI NL SE

(71) Anmelder: **Siemens Aktiengesellschaft**
**Wittelsbacherplatz 2**
**D-8000 München 2(DE)**

(72) Erfinder: **Bürk, Hermann, Dipl.-Ing. (FH)**
**Winklerweg 5**
**D-8901 Egling/Paar(DE)**
Erfinder: **Steinhauser, Michael, Dipl.-Chem.**
**Johann-Neumeier-Strasse 5**
**D-8031 Eichenau(DE)**
Erfinder: **Wagner, Thomas, Dipl.-Ing . (FH)**
**Hermanstrasse 19**
**D-8900 Augsburg(DE)**

(54) Verfahren zum Entschichten von Photolack.

(57) Insbesondere durch Ätzen mit fluorhaltigem Ätzgas gestreßter Photolack (5) ist naßchemisch in gängigen Entschichtern nur äußerst schwierig und kaum vollständig abzulösen. Es wird ein Verfahren vorgeschlagen, bei dem zur Unterstützung eines alkalischen Entschichterbades eine Elektrolyse durchgeführt wird, wobei das die gestreßte Photolackstruktur (5) tragende Substrat (1) als Kathode geschalten wird. Die bei der elektrolytischen Wasserzersetzung direkt an der Substratoberfläche bzw. an den freiliegenden metallischen Flächen (3, 4) entstehenden Gase bewirken eine vollständige Entschichtung der durch das alkalische Bad bereits angelösten Photolackstruktur (5). In besonders schwierigen Fällen kann das Verfahren mit einem weiteren Entschichtungsprozeß, zum Beispiel einem "Reinigungsvorgang" im Sauerstoffplasma kombiniert werden. Das neue Verfahren ist einfach und außerdem kostengünstiger und schneller durchzuführen als bekannte Verfahren.

FIG 1

FIG 3

## Verfahren zum Entschichten von Photolack.

Die Erfindung betrifft ein Verfahren zum Entschichten von insbesondere durch fluorhaltiges Plasma gestreßtem, über metallisch leitenden Schichten liegendem Photolack.

Zum Erzeugen von Strukturen, insbesondere Leiterbahnstrukturen in der Mikroelektronik, werden Photolacke verwandt. Dies sind lichtempfindliche Verbindungen, die durch Bestrahlung mit geeignetem Licht oder anderer Strahlung ihre chemische Struktur ändern und infolgedessen ein geändertes Löslichkeitsverhalten gegenüber unbestrahlten Lackflächen zeigen. In einem geeigneten Entwicklungsprozeß werden die nach Bestrahlung durch eine Maske bereits latent vorliegenden Strukturen der Lackschicht auch räumlich herausgebildet, indem die leichter löslichen Teile der Photolackschicht, welche je nach Photolack die belichteten oder unbelichteten sein können, herausgelöst werden.

Die so erzeugten Photolackstrukturen dienen nun als Maske für weitere Strukturierungsschritte der darunterliegenden Schichten. Es können sich zum Beispiel Ätzprozesse anschließen, bei denen selektiv die Teile der darunterliegenden Schicht geätzt werden, welche nicht von Photolack bedeckt sind.

Nach der Beendigung dieses Strukturierungsschrittes muß die Photolackschicht wieder entfernt werden. Dies kann jedoch zu Schwierigkeiten führen, da die Photolacke während des Ätzprozesses einer strukturellen und chemischen Veränderung unterliegen. Dabei spielen die thermische Beanspruchung und die Zusammensetzung des Ätzplasmas sowie auch die UV-Härtung des Photolacks eine wesentliche Rolle. In fluorhaltigem Ätzplasma (Prozeßgas zum Beispiel $CF_4$ oder $SF_6$) ist eine partielle bzw. Perfluorierung der Lackoberfläche durch Fluorradikale und andere reaktive Ätzgasfragmente (zum Beispiel fragmente (zum Beispiel $CF_3$, $SF_4$, $SF_2$, $COF_2$, $SOF_2$ usw.) wahrscheinlich. Man spricht auch von einer Teflonisierung.

Die während des Ätzvorganges gebildeten Metallfluoride können als Friedel-Craft-Katalysatoren zur zusätzlichen Vernetzung der Lackstruktur beitragen.

Weiterhin ist eine Adduktbildung der als Lewis-Säuren wirkenden Metallfluoride mit den Sauerstoffpositionen (Elektronen-Donor) im Photolack denkbar. Dadurch erhält der organische Lack eine anorganische Komponente und ist in Sauerstoffplasma nicht mehr rückstandslos entschichtbar. Im Extremfall bewirken diese beschriebenen Veränderungen die völlige Resistenz der Lackstruktur nach dem Ätzen gegen die üblicherweise verwendeten Lösungsmittel (= Lack-Stripper) wie Cellosolve oder Aceton.

Eine mit Fluorplasma (zum Beispiel $SF_6$ als Ätzgas) behandelte Photolackstruktur zeigt dabei nur an der dem Plasmaangriff ausgesetzten Oberfläche die genannten Eigenschaften, während der Lack im Inneren der Strukturen noch gut löslich ist.

Durch Eindiffundieren des Lösungsmittels oder nach Aufreißen der Außenschicht wird ein großer Teil des Lacks entfernt. Das selektive Herauslösen der "inneren" Lackschichten führt jedoch zur Ausbildung von Lackhäutchen, die zunächst nur an den Strukturkanten haften. Nach Extraktion der löslichen Innenschichten beginnen diese jedoch auf die Unterlage abzusinken und, besonders nach Verdunstung des Lösungsmittels, ganzflächig auf der Unterlage zu haften. Nach diesem Vorgang sind die Lackreste (Häutchen) infolge der starken Adhäsion und der Unlöslichkeit in organischen Lösungsmitteln naßchemisch nicht mehr entfernbar.

Diese Probleme treten besonders bei großflächigen Lackstrukturen (zum Beispiel Anschlußfahnen von Leiterbahnenstrukturen) oder bei besonders feinen Strukturen mit einem ungünstigen Verhältnis der Haftpunkte zur übrigen Lackoberfläche auf. Während sich im ersten Fall die teilweise abgelöste Lackhaut in unkontrollierbarer Weise über der geätzten Struktur zusammenfaltet und so mit die Waferfläche kontaminiert, werden bei feinen Strukturen besonders dicken Häutchen beobachtet. Aus diesen Gründen gestaltet sich die konventionelle Entschichtung nach einem Plasmaätzschritt besonders kritisch. Nach der Aceton-Entschichtung (auch nach vorangegangener Sauerstoffplasmavorbehandlung) ist die geätzte Metallstruktur an vielen Stellen noch mit einem massiven Lacküberzug bedeckt. Teilweise bricht der Lack an der Oberkante besonders feiner gewundener Lackstrukturen auf, wobei die entstandenen Hälften in die nicht von Lack bedeckten Zwischenräume klappen und zum Beispiel während einer anschließenden IBE-Ätzung (= Ionenstrahlätzung) eine unerwünschte Maske bilden.

Derartige Lackreste mit vermutlich anorganischer Komponente können erst durch eine zusätzliche Säurebehandlung wieder in eine rein organische Phase überführt werden, die in einem Sauerstoffplasma oxidierbar und somit entfernbar ist.

Aufgabe der vorliegenden Erfindung ist es daher, ein einfaches, schnelles und gründliches Verfahren zum Entschichten derartig gestreßter Photo--lackschichten anzugeben.

Diese Aufgabe wird durch ein Verfahren der eingangs genannten Art dadurch gelöst, daß es erfindungsgemäß folgende Schritte enthält:

a) Verbinden eines Substrats, welches die zu entschichtende Photolackschicht bzw. -struktur über einer metallisch leitenden Schicht bzw. Struktur enthält, mit einer Stromquelle,

b) Schalten einer Inertelektrode als Gegenelektrode,

c) Durchführen einer Elektrolyse in einem alkalischen Bad, wobei die Inertelektrode die eine und das Substrat bzw. dessen metallische Struktur die andere Elektrode darstellt und

d) Beenden der Elektrolyse, Herausnehmen und Abspülen des Substrats mit voll entsalztem Wasser.

Mit dem erfindungsgemäßen Verfahren können auch stark plasmagestreßte Photolackschichten vollständig und schnell entfernt werden. Das alkalische Bad wirkt dabei als Lösungsmittel für die leichter löslichen inneren Lackschichten. Die schwer löslichen äußeren Schichten (Lackhäutchen) werden durch die an der Oberfläche der metallischen Struktur durch elektrolytische Wasserzersetzung erzeugten Gasbläschen (Wasserstoff bzw. Sauerstoff) auf mechanischem Weg entfernt. Denkbar ist auch, daß die Lackentschichtung durch die stark reduzierende bzw. oxidierende Wirkung der entstehenden Gase auf chemischem Weg unterstützt wird.

Ein weiterer Vorteil des Verfahrens ist der geringe Zeitbedarf. Bereits nach einer Minute Elektrolyse sind Photolackstrukturen vollständig entschichtet. Gegenüber dem konventionellen Verfahren, bestehend aus einer Sauerstoffplasmabehandlung und einer anschließenden naßchemischen Entschichtung in Aceton oder Cellosolve ergibt sich einschließlich des in beiden Fällen sich anschließenden Spülvorgangs mit Propanol bzw. Wasser eine Zeitersparnis von ca. 50 Prozent (= ca. 25 Minuten).

Vorteilhafterweise wird das Substrat bzw. die darauf befindliche Metallstruktur während der Elektrolyse als Kathode geschaltet. Auf diese Weise kann ein Materialabtrag an der Anode, ausgelöst durch anodische Oxidation (bei gegenteiliger Schaltung), vermieden werden.

Als Elektrolyt können die Lösungen von Kalium- bzw. Natriumhydroxid in Wasser dienen. Diese Laugen, üblicherweise in einer Konzentration von ca. 5 Gewichtsprozent eingesetzt, vermögen bereits für sich den Photolack anzulösen. Doch ist die Auswahl alkalischer bzw. basischer Elektrolytlösungen nicht auf diese Stoffe begrenzt. Ebenso sind die Laugen der Hydroxide anderer Alkali-oder Erdalkalimetalle geeignet.

Weitere Vorteile werden mit der Verwendung einer organischen Base als Elektrolyt erzielt. Zur Auswahl stehen dabei alle Basen, die eine ausreichende Löslichkeit für Photolack aufweisen und als Elektrolyt stabil sind, das heißt, an der Anode bzw. Kathode keine oxidativen bzw. reduktiven Veränderungen erfahren. Durch diese organischen Basen wird die Kontamination der zu entschichtenden Substrate bzw. elektrischen und elektronischen Bauteile mit Alkaliionen, welche die Lebensdauer und Funktionssicherheit der Bauteile bzw. der Substrate beeinträchtigen, vermieden. Eine große Auswahl für diesen Zweck geeigneter Verbindungen steht in der Klasse der Amine und Aminoverbindungen zur Verfügung. Diese zeichnen sich durchwegs durch einen hohen $pK_s$-Wert aus, welcher ein Maß für die Basenstärke darstellt.

Die im erfindungsgemäßen Verfahren beschriebenen Maßnahmen können für sich allein bereits eine vollständige Entschichtung von gestreßtem Photolack bewirken. Doch ist das erfindungsgemäße Verfahren auch als zusätzliche Maßnahme in Verbindung mit anderen bereits bekannten Entschichtungsverfahren denkbar. So läßt sich die elektrolytische Entschichtung etwa mit einem vor- oder gegebenenfalls auch nachgeschalteten Reinigungsprozeß in einem Sauerstoffplasma verbinden. Durch Variation in der Prozeßabfolge und durch zeitliches aufeinander Abstimmen der Prozeßdauer läßt sich so jedes Entschichtungsproblem lösen.

Bei nicht ausschließlich elektrolytischer Lackentschichtung, also bei einer Kombination des erfindungsgemäßen Verfahrens mit bekannten Verfahren ist auch eine saure Elektrolytlösung möglich, was für Anwendungsfälle mit erforderlichem Basenausschluß von Bedeutung ist.

Im folgenden wird die Erfindung anhand eines Ausführungsbeispiels und der drei Figuren noch näher erläutert.

Die Figuren zeigen im Querschnitt verschiedene Verfahrensstufen bei der Herstellung eines Dünnfilmmagnetkopfes und beinhalten einen Entschichtungsschritt.

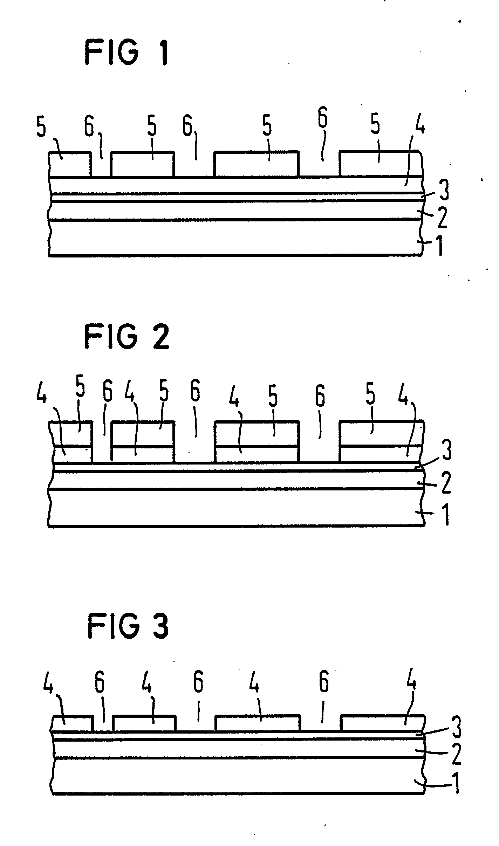

Figur 1: Auf einem Substrat 1, hier ein Titancarbidwafer, befindet sich eine Kupferschicht 2 von ca. 4 μm Stärke, die zum Schutz gegen Korrosion (zum Beispiel Kupfersulfidbildung) mit einer ca. 50 nm dicken Permalloyschicht 3 (= Eisen/Nickellegierung) überzogen ist. Darüber befindet sich eine Tantalschicht 4 von ca. 1,7 μm Stärke. Eine Photolackschicht 5 (zum Beispiel HPR 206) wird ganzflächig aufgebracht, in bekannter Weise über Bestrahlung mit UV-Licht durch eine Maske strukturiert und schließlich entwickelt. Die Figur zeigt die nach der Entwicklung der bestrahlten Lackschicht stehengebliebenen Photolackstrukturen 5 über der unversehrt gebliebenen Tantalschicht 4. Beim nun folgenden Ätzprozeß dienen diese Lackstrukturen 5 als Maske für die Strukturierung der Tantalschicht 4. In deren freiliegenden Bereichen 6 wird durch Beschuß mit einem fluorionenhaltigem Plasma (Ätzgas zum Beispiel CF₄ oder SF₆) die Schicht 4 bis auf die darunterliegende Permalloyschicht 3 abgetragen.

Figur 2 zeigt, wie die Tantalschicht 4 entsprechend der Photolackstruktur 5 strukturiert ist. In den Bereichen 6 ist nun die Permalloyschicht 3 freigelegt.

Durch diesen Ätzprozeß werden die Lackstrukturen durch chemische Reaktion mit flurohaltigen Ätzgasfragmenten (zum Beispiel $CF_3$, $SF_4$, $SF_2$, $SOF_2$ usw.) in ihrem Verhalten gegen gängige Lackstripper wie Aceton oder Cellosolve derart verändert, daß sie weder durch organische Lösungsmittel noch durch Ätzen im Sauerstoffplasma vollständig entfernbar sind. Daher wird der Wafer über eine seiner Metallschichten (2, 3 oder 4) mit der Anode einer Konstantstromquelle elektrisch leitend verbunden. Eine Inertelektrode, zum Beispiel aus platiniertem Titan, wird als Anode geschaltet und in eine Entschichterlösung, bestehend aus 5 %iger KOH oder NaOH, eingetaucht. Nun wird der Stromkreis geschlossen und der Wafer ebenfalls in die Entschichterlösung eingetaucht. Die Lauge löst die Lackschichten 5 an und legt Bereiche der darunterliegenden Tantalstruktur frei. In diesen Bereichen findet nun, ebenso wie an den bereits freiliegenden Bereichen 6 der Permalloyschicht 3, eine kräftige Gasentwicklung (Wasserstoff) durch elektrolytische Zersetzung von Wasser statt. Die direkt an den Metalloberflächen entstehenden Gasperlen lösen sich von diesen ab, steigen in der Lösung nach oben und unterstützen dadurch mechanisch die Lackablösung. Die in der Lauge unlöslichen äußeren Lackhäutchen werden dadurch aufgebläht, am Zusammenfallen und Festkleben an der Unterlage gehindert und schließlich ganz von der Tantalschicht 4 abgelöst. Bei einer Elektrolysestromdichte von ca. 20 A/dm² ist die Photolackstruktur 5 nach ca. 1 Minute vollständig entfernt. Der Wafer wird aus dem Bad genommen, mit voll entsalztem Wasser gespült, getrocknet und kann nun dem nächsten Prozeßschritt zugeführt werden.

Mit dem erfindungsgemäßen Verfahren wird gegenüber der bisher üblichen naßchemischen Entschichtung eine große Zeitersparnis erzielt (zum Beispiel 1 Minute elektrolytische Entschichtung : 15 Minuten naßchemische Entschichtung). Das Verfahren beseitigt selbst stark plasmagestreßten Photolack, auch solchen mit ungünstiger Struktur, zum Beispiel mit schmalen Strukturbreiten, engen Windungen und vielen Kanten. Es wird ein kostengünstiges und nicht flüchtiges Lösungsmittel verwendet, das zudem nicht brennbar ist. Außerdem kann es in einer einfachen Galvanikapparatur und in großem Maßstab durchgeführt werden.

## Ansprüche

1. Verfahren zum Entschichten von insbesondere durch fluorhaltiges Plasma gestreßtem, über metallisch leitenden Schichten liegendem Photolack, **dadurch gekennzeichnet, daß** es folgende Verfahrensschritte enthält:

a) Verbinden eines Substrats (1), welches die zu entschichtende Photolackschicht bzw. Struktur (5) über einer metallisch leitenden Schicht bzw. Struktur (4) enthält mit einer Stromquelle,

b) Schalten einer Inertelektrode als Gegenelektrode,

c) Durchführen einer Elektrolyse in einem alkalischen Bad, wobei das Substrat (1) und die Inertelektrode die Elektroden darstellen und

d) Beenden der Elektrolyse, Herausnehmen und Abspülen des Substrats (1) mit voll entsalztem Wasser.

2. Verfahren nach Anspruch 1, **dadurch gekennzeichnet,** daß für das alkalische Bad als Elektrolyt eine wäßrige Alkalihydroxidlösung verwendet wird.

3. Verfahren nach Anspruch 2, **dadurch gekennzeichnet,** daß die Konzentration des Alkalihydroxid zwischen 1 und 10 Gewichtsprozent eingestellt wird.

4. Verfahren nach Anspruch 1, **dadurch gekennzeichnet,** daß eine organische Base als Elektrolyt verwendet wird.

5. Verfahren nach mindestens einem der Ansprüche 1 bis 4, **dadurch gekennzeichnet,** daß die elektrolytische Lackentschichtung mit weiteren Entschichtungsverfahren kombiniert wird.

6. Verfahren nach mindestens einem der Ansprüche 1 bis 5, **da durch gekennzeichnet,** daß vor oder nach der Elektrolyse in einem alkalischen Bad eine weitere Elektrolyse in einem sauren Bad durchgeführt wird.

7. Verfahren nach mindestens einem der Ansprüche 1 bis 4, **dadurch gekennzeichnet,** daß die Elektrolyse mit einer Konstantstromquelle durchgeführt wird.

8. Verfahren nach mindestens einem der Ansprüche 1 bis 7, **dadurch gekennzeichnet,** daß das Substrat (1) als Kathode geschaltet wird.

# FIG 1

# FIG 2

# FIG 3

# EUROPÄISCHER RECHERCHENBERICHT

| EINSCHLÄGIGE DOKUMENTE | EP 89106277.0 |

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DD - B1 - 220 623<br>(MASCHINENFABRIK SANGERHAUSEN)<br>* Seite 1, Zeilen 30-48 * | 1-3 | C 25 F 5/00<br>H 01 L 21/312 |
| A | US - A - 3 900 337<br>(BECK)<br>* Zusammenfassung * | 1-8 | |
| A | DE - C2 - 2 632 949<br>(ALLIED CORP.) | | |

RECHERCHIERTE
SACHGEBIETE (Int. Cl.4)

C 25 F
H 01 L 21/00

Der vorliegende Recherchenbericht wurde für alle Patentansprüche erstellt.

| Recherchenort | Abschlußdatum der Recherche | Prüfer |
|---|---|---|
| WIEN | 19-06-1989 | ONDER |